# EUROPÄISCHE PATENTSCHRIFT

(11) **EP 2 432 915 B1**
(45) Veröffentlichungstag und Bekanntmachung des Hinweises auf die Patenterteilung: **05.06.2013**
(21) Anmeldenummer: 10721479.3
(22) Anmeldetag: 19.05.2010
(51) Int. Cl.: C23C 14/06, F16J 9/26

(54) **Gleitelement.**
Sliding element.
Élément de glissement.

(30) Priorität: 19.05.2009 DE 102009003232
(43) Veröffentlichungstag der Anmeldung: 28.03.2012
(73) Patentinhaber: Federal-Mogul Burscheid GmbH, 51399 Burscheid (DE)
(72) Erfinder: HOPPE, Steffen, 51491 Overath (DE); FISCHER, Manfred, 42799 Leichlingen (DE); KENNEDY, Marcus, 40479 Düsseldorf (DE)
(74) Vertreter: HOFFMANN EITLE
(86) Internationale Anmeldenummer: PCT/EP2010/056885
(87) Internationale Veröffentlichungsnummer: WO 2010/133633

(56) Entgegenhaltungen:
- EP-A1- 1 992 715
- DE-A1- 19 625 329
- DE-U1- 29 605 666
- SIEGAL M P ET AL: "Bonding topologies in diamondlike amorphous-carbon films" APPLIED PHYSICS LETTERS, AIP, AMERICAN INSTITUTE OF PHYSICS, MELVILLE, NY, US LNKD- DOI:10.1063/1.126250, Bd. 76, Nr. 15, 10. April 2000 (2000-04-10), Seiten 2047-2049, XP012025020 ISSN: 0003-6951
- ROBERTSON J: "Diamond-like amorphous carbon" 24. Mai 2002 (2002-05-24), MATERIALS SCIENCE AND ENGINEERING R: REPORTS, ELSEVIER SEQUOIA S.A., LAUSANNE, CH LNKD- DOI:10.1016/S0927-796X(02)00005-0, PAGE(S) 129 - 281 , XP004356348 ISSN: 0927-796X Absatz [6.1 6.2]
- SPAETH C ET AL: "Mechanical properties of carbon nitride thin films prepared by ion beam assisted filtered cathodic vacuum arc deposition" SURFACE AND COATINGS TECHNOLOGY ELSEVIER SWITZERLAND, Bd. 112, Nr. 1-3, Februar 1999 (1999-02), Seiten 140-145, XP002579153 ISSN: 0257-8972
- SHEEJA D ET AL: "Structural and tribological characterization of multilayer Ta-C films prepared by filtered cathodic vacuum arc with substrate pulse biasing" SURFACE AND COATINGS TECHNOLOGY ELSEVIER SWITZERLAND, Bd. 132y, Nr. 2-35,6, 23. Oktober 2000 (2000-10-23), Seiten 228-232, XP002579152 ISSN: 0257-8972

## Beschreibung

### Gebiet der Erfindung

Die Erfindung betrifft ein Gleitelement in einem Verbrennungsmotor, insbesondere einen Kolbenring.

Bei der Reduzierung der Kohlendioxidemissionen von Verbrennungsmotoren spielt der Kraftstoffverbrauch eine maßgebliche Rolle. Dieser wird von den Reibungsverlusten im Motor, insbesondere im Bereich der Kolben, beispielsweise an den Kolbenringen, maßgeblich beeinflusst. Es besteht deshalb die Forderung nach Gleitelementen in Verbrennungsmotoren, insbesondere Kolbenringen, die über die gesamte Lebensdauer ein möglichst günstiges Reibungsverhalten aufweisen. Im Hinblick auf die gesamte Lebensdauer ist insbesondere das Einlaufverhalten, eine mögliche Mangelschmierung und eine eventuelle Brandspurbildung zu berücksichtigen, die jeweils zu veränderten tribologischen Eigenschaften führen.

### Stand der Technik

Auf dem vorgenannten Gebiet sind PVD-Beschichtungen auf Hartstoffbasis bekannt, die eine gute Verschleißbeständigkeit aufweisen, jedoch im Hinblick auf die Reibkoeffizienten verbesserungswürdig sind.

Aus der DE 10 2005 063 123 B3 geht ein Schichtaufbau hervor, der, von außen nach innen, eine Einlaufschicht, eine Haftschicht und eine Verschleißschutzschicht aufweist. Das Verhalten der Reibeigenschaften über die Lebensdauer hat sich jedoch als weiter verbesserbar herausgestellt.

Die US 6,528,115 betrifft ein Gleitelement mit einer Kohlenstoffbeschichtung mit veränderlichem sp²/sp³-Verhältnis, das insbesondere von dem Substrat ausgehend abnehmen und zur Außenseite der Beschichtung hin wieder zunehmen kann.

### Aufgabe der Erfindung

Der Erfindung liegt die Aufgabe zugrunde, ein Gleitelement eines Verbrennungsmotors, insbesondere einen Kolbenring zu schaffen, das/der eine Beschichtung aufweist, die zuverlässig, über einen möglichst langen Zeitraum, günstige Reibeigenschaften besitzt.

Die Lösung der Aufgabe erfolgt durch das im Anspruch 1 beschriebene Gleitelement.

Indem zufolge weist dieses eine DLC-Beschichtung des Typs ta-C auf, die über ihre Dicke veränderliche Eigenspannungen besitzt. Mit anderen Worten ist über die Dicke der Beschichtung zumindest ein Eigenspannungsgradient ausgebildet. Mit "DLC" wird bekanntermaßen diamond-like carbon beschrieben. Der Typ ta-C zeichnet sich durch einen tetraedrischen Aufbau auf, ist wasserstofffrei und beispielsweise in der VDI Richtlinie 2840 definiert. Eine derartige Schicht sorgt zum einen für ein gutes Reibungsverhalten und weist darüber hinaus aus folgenden Gründen eine besonders hohe Lebensdauer auf.

Zum einen gestattet die Variation der Eigenspannungen über die Dicke der Schicht die Erzeugung großer Schichtdicken, von beispielsweise größer als 10 µm, ohne dass Probleme im Hinblick auf die Haftung oder Sprödigkeit der Schicht auftreten. Es konnte nämlich festgestellt werden, dass beispielsweise Zonen niedriger Schichteigenspannungen den gesamten Schichtverbund, d.h. die insbesondere mehrschichtig vorgesehene Beschichtung, lokal relaxieren oder entspannen. Hierdurch wird bei hohen Schublastspannungen, wie sie beim Einsatz in einem Verbrennungsmotor auftreten, die Fließgrenze der DLC-Beschichtung nicht überschritten. Der Verschleiß der Beschichtung kann demnach erfolgreich eingegrenzt werden.

Für einen mittleren, d.h. nicht ganz außen und nicht ganz innen liegender Bereich der Beschichtung hat sich ein negativer Eigenspannungsgradient bewährt, der bevorzugt geringer ist als der negative Eigenspannungsgradient im inneren, d.h. zu dem Grundwerkstoff gelegenen Bereich der Beschichtung. Hierdurch liegt die Eigenspannung mit dem höchsten Niveau vergleichsweise weit außen an der Beschichtung, was ein günstiges Verhalten erwarten lässt. In diesem Zusammenhang weist der mittlere Bereich eine größere, bevorzugt deutlich größere, etwa dreimal so große, Schichtdicke auf wie der innen liegende Bereich.

Bevorzugte Weiterbildungen des erfindungsgemäßen Gleitelements sind in den weiteren Ansprüchen beschrieben.

Für den Übergang von der Beschichtung zu dem Grundwerkstoff des Gleitelements hat sich in diesem, d.h. einem inneren Bereich der Beschichtung ein, von außen nach innen betrachtet, negativer Eigenspannungsgradient als vorteilhaft erwiesen. Mit anderen Worten sinken die Eigenspannungen zu dem Grundwerkstoff hin auf einen niedrigen Wert, um einen günstigen Spannungsübergang zum Grundwerkstoff und eine gute Haftung der Schicht zu erreichen.

Für einen außen liegenden Bereich hat sich ein, von außen nach innen betrachtet, positiver Eigenspannungsgradient als vorteilhaft erwiesen. Mit anderen Worten liegt die Eigenspannung an der äußeren Oberfläche der Beschichtung auf einem vergleichsweise niedrigen Niveau, was sich für ein günstiges Einlaufverhalten als vorteilhaft erwiesen hat. Hiervon ausgehend steigen die Eigenspannungen jedoch bevorzugt nach innen hin stark an, so dass sich die oben beschriebenen Wirkungen erzielen lassen.

Insbesondere bei Gleitelementen, für die eine extrem hohe Flächenpressung zu erwarten ist, ist ein konstanter, niedriger Eigenspannungsverlauf in einem innersten Bereich, d.h. unmittelbar an den Grundwerkstoff angrenzend, günstig.

Ferner kann durch einen ebenfalls konstanten, vergleichsweise niedrigen, jedoch bevorzugt auf höherem Niveau als im innersten Bereich liegenden Eigenspannungsverlauf, der an der Außenseite der Beschichtung vorgesehen ist, das Einlaufverhalten weiter verbessert werden.

Für die Vermeidung der Ausbreitung von Rissen in der Beschichtung haben sich bei einer alternativen, hierin ebenfalls beschriebenen Ausführungsform, in einem mittleren Bereich umfangreich alternierende Eigenspannungen als vorteilhaft herausgestellt. Das Maß der Zonen niedriger Eigenspannungen kann in diesem Zusammenhang kleiner, gleich oder größer als das Maß der Zonen mit hoher Eigenspannung sein.

Für die Periodizität, d.h. die Dicke zwischen dem Beginn eines Bereichs niedriger Eigenspannung, über einen Bereich hoher Eigenspannung bis zu dem Beginn des nächsten Bereichs mit niedriger Eigenspannung, sind Werte von 0,01 bis 1 µm denkbar.

Insgesamt lassen sich durch die beschriebenen Maßnahmen Beschichtungen mit einer Dicke von 10 µm oder größer erzeugen, was zum einen ein günstiges Einlaufverhalten bewirkt jedoch gleichzeitig eine ausreichende Schichtdicke darstellt, um nach unvermeidbaren Verschleiß eine lange Lebensdauer mit günstigen Reibeigenschaften der Beschichtung sicherzustellen.

Für die Erzeugung der unterschiedlichen Eigenspannungen ist beispielsweise eine Veränderung des Verhältnisses zwischen sp2- und sp3-hybridisierten Kohlenstoffatomen vorteilhaft. Insbesondere können die Druckeigenspannungen durch Erhöhung des sp3-Anteils erhöht werden, was insgesamt die Ausbildung eines Eigenspannungsgradienten ermöglicht.

Dies gilt in ähnlicher Weise bei zunehmender Dichte, so dass für eine Änderung der Dichte der Schicht über deren Dicke die Möglichkeit erwartet wird, die Eigenspannungen in vorteilhafter Weise über die Dicke der Schicht zu verändern.

Schließlich ist ins Auge gefasst, die Härte der Schicht über deren Dicke zu verändern, da eine höhere Härte größere Druckeigenspannungen zur Folge hat, so dass sich hierdurch ebenfalls die gewünschten Eigenspannungsgradienten einstellen lassen.

### Kurze Beschreibung der Zeichnungen

Nachfolgend werden Ausführungsformen der Erfindung beispielhaft unter Bezugnahme auf die Zeichnungen näher erläutert. Es zeigen:
- Fig. 1: eine Darstellung des Eigenspannungsverlaufs über die Dicke einer DLC-Beschichtung in einer ersten Ausführungsform; und
- Fig. 2: eine Darstellung des Eigenspannungsverlaufs über die Dicke einer DLC-Beschichtung in einer zweiten, nicht erfindungsgemäßen Ausführungsform.

### Ausführliche Beschreibung der Zeichnungen

In den Figuren sind die Eigenspannungen der DLC-Beschichtung jeweils über die Dicke der Beschichtung angetragen, wobei ein äußerster Bereich der Beschichtung in den Diagrammen links, und ein innerster Bereich der Beschichtung rechts liegt. Mit anderen Worten schließt sich rechts an die Beschichtung mit den dargestellten Eigenspannungen der Grundwerkstoff, beispielsweise Stahl oder Grauguss, an.

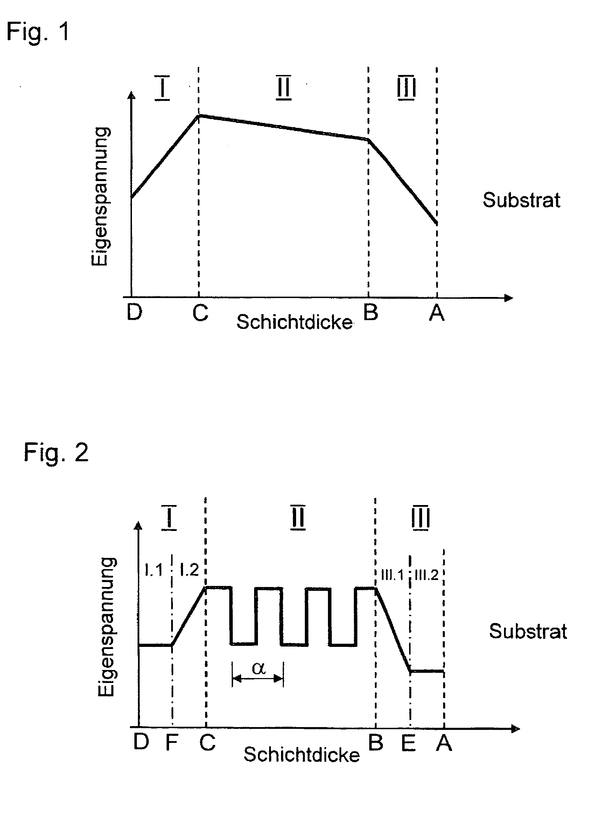

Bei der Ausführungsform von Fig. 1 ist von dem inneren Bereich, oder dem "Boden" der Beschichtung ausgehend (Zone III) ein (von außen nach innen) negativer Eigenspannungsgradient ausgebildet. Mit anderen Worten sind die Eigenspannungen an dem Übergang zu dem Grundwerkstoff besonders niedrig, um einen guten Spannungsübergang und eine gute Haftung der Beschichtung zu erzielen. In einem mittleren Bereich (Zone II) erhöht sich die Eigenspannung weiter, jedoch mit niedrigerem Gradienten, auf das höchste Niveau. An der Außenseite (Zone I) sinken die Eigenspannungen stark ab, mit anderen Worten ist von außen nach innen ein hoher positiver Eigenspannungsgradient ausgebildet, was zu einem günstigen Einlaufverhalten führt. Hierbei ist der mittlere Bereich II deutlich größer als der innere III und/oder der äußere Bereich I. Bevorzugt ist der mittlere Bereich II größer als beide genannten anderen Bereiche I und III. Diese beiden Bereiche I, III können in etwa gleich dick sein. Der mittlere Bereich II ist bevorzugt deutlich dicker als die beiden anderen Bereiche, und insbesondere etwa dreimal so dick wie jeder der anderen Bereiche I, III.

Bei der Ausführungsform von Fig. 2 sind in einer äußersten Zone I die Eigenspannungen zunächst auf niedrigem Niveau konstant und steigen dann (Zone 1.2) stark an. Dies sorgt für einen beanspruchungsgerechten Übergang zwischen der Zone I und einer Zone II, in der die Eigenspannungen umfangreich alternieren. Insbesondere bei Schubspannungsbelastung hat sich nämlich ein konstant hoher Eigenspannungszustand als rissgefährdet erwiesen. Die alternierenden Eigenspannungen in der Zone II unterbinden die Rissausbreitung. In diesem Bereich kann die Periodizität α beispielsweise zwischen 0,1 und 1 µm liegen. Ähnlich wie bei der Ausführungsform von Fig. 1 schließt sich zu dem Grundwerkstoff hin (in der Figur rechts) eine Zone III.1 mit einem stark negativen Eigenspannungsgradienten an, und unmittelbar an den Grundwerkstoff angrenzend ist eine Zone III.2 mit einem konstant niedrigen Eigenspannungsverlauf vorgesehen, um einen guten Spannungsübergang zum Grundwerkstoff und eine gute Haftung zu erreichen. Das Eigenspannungsniveau in der Zone III.2 kann insbesondere niedriger sein, als das in der äußersten Zone I.1, und in der Zone II können die Eigenspannungen zwischen absoluten Maximalwerten und einem Niveau ein wenig oberhalb des Niveaus der Zone I variieren.

Es sei ergänzt, dass die Bereiche I, die von dem Punkt D zu dem Punkt C reichen, beider Figuren in etwa einander entsprechen. Dies gilt in gleicher Weise für den mittleren Bereich II, d.h. zwischen den Punkten C und B, und den jeweiligen Bereich III, mit anderen Worten zwischen den Punkten B und A. Insbesondere gelten die oben genannten Dickenverhältnisse auch für die Fig. 2. Es sei schließlich erwähnt, dass die einzelnen Merkmale der genannten Ausführungsformen miteinander kombiniert werden können, soweit sie einander nicht widersprechen.

## Patentansprüche

1. Gleitelement eines Verbrennungsmotors, insbesondere Kolbenring, mit einer DLC-Beschichtung des Typs ta-C, die über ihre Dicke veränderliche Eigenspannungen und somit zumindest einen Eigenspannungsgradienten aufweist, **dadurch gekennzeichnet, dass** in einem mittleren Bereich (II) der Beschichtung ein, von außen nach innen betrachtet, negativer Eigenspannungsgradient ausgebildet ist, der bevorzugt kleiner ist, als in einem innen liegenden Bereich (III), und dass der innen liegende Bereich (III) eine geringere Schichtdicke aufweist als der mittlere Bereich (II), wobei die Beschichtung 10 µm oder dicker ist.

2. Gleitelement nach Anspruch 1, **dadurch gekennzeichnet, dass** in einem zu dem Grundwerkstoff gelegenen Bereich (III) ein, von außen nach innen betrachtet, negativer Eigenspannungsgradient ausgebildet ist.

3. Gleitelement nach Anspruch 1 oder 2, **dadurch gekennzeichnet, dass** in einem außen liegenden Bereich (I) ein, von außen nach innen betrachtet, positiver Eigenspannungsgradient ausgebildet ist.

4. Gleitelement nach einem der vorangehenden Ansprüche, **dadurch gekennzeichnet, dass** in einem innersten (III.2) und/oder äußersten Bereich (I.1) der Beschichtung die Eigenspannungen weitgehend konstant sind.

5. Gleitelement nach einem der vorangehenden Ansprüche, **dadurch gekennzeichnet, dass** in einem innersten Bereich die Eigenspannungen niedriger sind als in einem äußersten Bereich der Beschichtung.

6. Gleitelement nach einem der vorangehenden Ansprüche, **dadurch gekennzeichnet, dass** in zumindest einem Bereich mit einem Eigenspannungsgradienten ein sich veränderndes Verhältnis zwischen sp2- und sp3-hybridisierten Kohlenstoffatomen vorliegt.

7. Gleitelement nach einem der vorangehenden Ansprüche, **dadurch gekennzeichnet, dass** in zumindest einem Bereich mit einem Eigenspannungsgradienten eine sich verändernde Dichte der Schicht vorliegt.

8. Gleitelement nach einem der vorangehenden Ansprüche, **dadurch gekennzeichnet, dass** in zumindest einem Bereich mit einem Eigenspannungsgradienten eine sich verändernde Härte der Schicht vorliegt.

## Claims

1. Sliding element of an internal combustion engine, in particular piston ring, having a DLC coating of the type ta-C, which has over its thickness, variable internal stresses and hence at least one internal stress gradient, **characterised in that** in a central region (II) of the coating, seen from the outside inwards, a negative internal stress gradient is formed which is preferably less than in an inner-lying region (III), and **in that** the inner-lying region (III) has a lower layer thickness than the central region (II), wherein the coating is 10 µm or thicker.

2. Sliding element according to claim 1, **characterised in that** in a region (III) facing the base material, seen from the outside inwards, a negative internal stress gradient is formed.

3. Sliding element according to claim 1 or 2, **characterised in that** in an outer-lying region (I), seen from the outside inwards, a positive internal stress gradient is formed.

4. Sliding element according to one of the preceding claims, **characterised in that** in an innermost (III.2) and/or outermost region (I.1) of the coating, the internal stresses are largely constant.

5. Sliding element according to one of the preceding claims, **characterised in that** in an innermost region, the internal stresses are lower than in an outermost region of the coating.

6. Sliding element according to one of the preceding claims, **characterised in that** in at least one region with an internal stress gradient, there is a changing ratio between sp2-hybridised and sp3-hybridised carbon atoms.

7. Sliding element according to one of the preceding claims, **characterised in that** in at least one region with an internal stress gradient, there is a changing density of the layer.

8. Sliding element according to one of the preceding claims, **characterised in that** in at least one region with an internal stress gradient, there is a changing hardness of the layer.

## Revendications

1. Elément de glissement d'un moteur à combustion interne, en particulier segment de piston, avec un revêtement DLC de type ta-C, lequel présente des contraintes résiduelles variables sur son épaisseur et par conséquent au moins un gradient de contrainte résiduelle, **caractérisé en ce que**, dans une zone centrale (II) du revêtement, un gradient de contrainte résiduelle négatif est formé en allant de l'extérieur vers l'intérieur, lequel est préférentiellement plus petit que dans une zone interne (III), et **en ce que** la zone interne (III) présente une épaisseur de couche inférieure à la zone centrale (II), l'épaisseur de revêtement étant supérieure ou égale à 10 µm.

2. Elément de glissement selon la revendication 1, **caractérisé en ce qu'**un gradient de contrainte résiduelle négatif est formé en allant de l'extérieur vers l'intérieur dans une zone (III) située vers le matériau de base.

3. Elément de glissement selon la revendication 1 ou 2, **caractérisé en ce qu'**un gradient de contrainte résiduelle positif est formé en allant de l'extérieur vers l'intérieur dans une zone externe (I).

4. Elément de glissement selon l'une des revendications précédentes, **caractérisé en ce que** les contraintes résiduelles sont pratiquement constantes dans la zone la plus interne (III.2) et/ou la plus externe (I.1) du revêtement.

5. Elément de glissement selon l'une des revendications précédentes, **caractérisé en ce que** les contraintes résiduelles sont moindres dans la zone la plus interne que dans la zone la plus externe du revêtement.

6. Elément de glissement selon l'une des revendications précédentes, **caractérisé en ce que** dans au moins une zone avec un gradient de contrainte résiduelle, un rapport variable est présenté entre les atomes de carbone hybridisés sp2 et sp3.

7. Elément de glissement selon l'une des revendications précédentes, **caractérisé en ce que** dans au moins une zone avec un gradient de contrainte résiduelle, une épaisseur variable de couche est présentée.

8. Elément de glissement selon l'une des revendications précédentes, **caractérisé en ce que** dans au moins une zone avec un gradient de contrainte résiduelle, une dureté variable de couche est présentée.
